Europäisches Patentamt

European Patent Office

Office européen des brevets

(19)

(11) Publication number: 0 112 078
A2

(12) **EUROPEAN PATENT APPLICATION**

(21) Application number: 83307178.0

(22) Date of filing: 24.11.83

(51) Int. Cl.³: **H 01 L 29/60**
**H 01 L 21/82, G 11 C 17/00**

(30) Priority: 03.12.82 JP 212462/82

(43) Date of publication of application:
27.06.84 Bulletin 84/26

(84) Designated Contracting States:
DE FR GB

(71) Applicant: FUJITSU LIMITED
1015, Kamikodanaka Nakahara-ku
Kawasaki-shi Kanagawa 211(JP)

(72) Inventor: Arakawa, Hideki
Asahi-so 13-17, Umegaoka
Midori-ku Yokohama-shi Kanagawa 227(JP)

(72) Inventor: Kawashima, Hiromi
Fujitsu Dai-3 Fujigaoka-ryo 2-1-2, Fujigaoka
Midori-ku Yokohama-shi Kanagawa 227(JP)

(74) Representative: Rackham, Stephen Neil et al,
GILL JENNINGS & EVERY 53-64 Chancery Lane
London WC2A 1HN(GB)

(54) A semiconductor memory element and a method for manufacturing it.

(57) A two-transistor cell semiconductor memory element includes a memory transistor Trm having a floating gate FG formed on a semiconductor substrate SUB above a first insulating layer $OX_1$ and a control gate CG superimposed on the floating gate FG through a second insulating layer $OX_2$, and a select transistor Trs for selecting the memory transistor Trm. The select transistor includes a first gate electrode PA formed on a first insulating layer $OX_1$ and a second gate electrode $P_B$ superimposed on the first gate electrode above a second insulating layer $OX_2$. The first and second gate electrodes are electrically connected to each other. Thus the select transistor has a double gate structure as well as the memory transistor. This prevents undesired shortening of the gate length of the select transistor Trs.

Fig. 5C

EP 0 112 078 A2

- 1 -

A SEMICONDUCTOR MEMORY ELEMENT
AND A METHOD FOR MANUFACTURING IT

The present invention relates to a semiconductor memory element. More particularly, the present invention relates to the structure of a select transistor in a non-volatile memory element having a two-transistor cell structure comprising a memory transistor and a select transistor.

An example of a memory element having a two-transistor cell structure comprises a memory transistor of the Flotox type having a floating gate and a control gate formed by the double self-aligning technique, and a select transistor consisting of an ordinary MOS transistor. This memory element forms an electrically rewritable read-only memory element and the rewriting of information into it is effected by the tunnel injection of electrons into its floating gate.

In this type of memory transistor, by maintaining the control gate or the drain at a high level, for example, about 20 V, or at a low level, for example, 0 V, electrons are injected into or emitted from the floating gate through the tunnel gate oxide film, so that erasure or the writing of information is effected.

The select transistor which acts on rewriting information into the memory transistor has a predetermined threshold voltage (Vth), and it is sufficient if this transistor has an ordinary gate function.

In the conventional two-transistor cell structure, the select transistor is constructed from an MOS transistor having a single-layer gate structure. In this case, problems due to the preparation process, such as a reduction of the performance and a reduction of the integration density, arise.

According to a first aspect of this invention a semiconductor memory element having a two-transistor cell structure comprising a memory transistor including a floating gate formed on a semi-conductor substrate through a first insulating layer and a control gate superimposed on the floating gate above a second insulating layer, and a select transistor for selecting the memory transistor, wherein the select transistor includes a first gate electrode formed on a first insulating layer is characterised in that the select transistor also includes a second gate electrode superimposed on the first gate electrode above a second insulating layer, the first and second gate electrodes being electrically connected to one another.

According to a second aspect of this invention a method of forming such a memory element comprises the steps of:-

forming a field oxide film on a semi-conductor substrate;

forming a first gate insulation film on an exposed surface of the semiconductor substrate;

forming a first conductive layer on the semi-conductor substrate;

patterning the first conductive layer;

forming a second gate insulation film on the first conductive layer;

forming a contact window on the second gate insulation film for electrically communicating the first conductive layer with a second conductive layer;

forming a second conductive layer on the second gate insulation film, and over the contact window to electrically connect the second and first conductive layers;

patterning the second conductive layer to form the control gate and another second gate;

removing the exposed second gate insulation film and patterning the first conductive layer to form a first gate of the select transistor and the floating gate of the memory transistor; and,

forming a source region and a drain region in the semi-conductor substrate.

The present invention provides a gate structure for the select transistor which has an ordinary gate function, but since it is arranged in parallel to the memory transistor by adopting a double self-aligning technique, the shortening of the substantial gate length of the select transistor is prevented.

One particular example of the method comprises the steps of: forming a field oxide film on a P-type silicon substrate; forming a first gate oxide film having a thickness of from about 300 $\overset{o}{A}$ to about 1500 $\overset{o}{A}$ on the exposed surface of the P-type silicon substrate; forming a first polysilicon layer having a thickness of from about 500 $\overset{o}{A}$ to about 5,000 $\overset{o}{A}$ on the first gate oxide film; patterning the first polysilicon layer; forming a second gate oxide film having a thickness of from about 300 $\overset{o}{A}$ to about 1500 $\overset{o}{A}$ on the first polysilicon layer; forming a contact window on the second gate oxide film for electrically communicating the first polysilicon layer with a second polysilicon layer; forming the second polysilicon layer having a thickness of from about 500 $\overset{o}{A}$ to about 5,000 $\overset{o}{A}$ on the second gate oxide film; patterning the first polysilicon layer; removing the exposed second gate oxide film and patterning the second polysilicon layer for forming a gate of the select transistor, a gate of the memory transistor, and a gate of a tunnel portion; and implanting ions on the exposed surface of the P-type silicon substrate so that an $N^+$-type source region and an $N^+$-type drain region are formed.

Particular embodiments of a memory element and a method in accordance with this invention will now be described and contrasted with the prior art with reference to the accompanying drawings; in which:-

Figure 1 is a circuit diagram of a conventional two-transistor cell;

Figure 2 is a diagrammatic section through the two-transistor cell shown in Figure 1;

Figures 3A and 3B are plans of the cell shown in Figure 1;

Figure 4 is a diagrammatic section through the cell shown in Figure 1 illustrating problems involved in the conventional technique;

Figures 5A and 5B are plans of one embodiment of the present invention;

Figure 5C is a section taken along the line A'-A shown in Figure 5B;

Figure 5D is a section taken along the line B-B' shown in Figure 5B;

Figure 5E is a section taken along the line C-C' shown in Figure 5B;

Figure 6 is a process diagram illustrating the production process according to one embodiment of the present invention;

Figures 7A to 7H are step diagrams of a section taken along the line A-A' in Figure 5B in the embodiment illustrated in Figure 6;

- 5 -

Figures 8A to 8J are step diagrams of a section taken along the line B-B' in Figure 5B in the embodiment illustrated in Figure 6;

Figures 9A to 9F are step diagrams of a section taken along the line C-C' in Figure 5B in the embodiment illustrated in Figure 6; and,

Figure 10 is a plan showing a pattern of a first polysilicon layer in the embodiment illustrated in Figure 6.

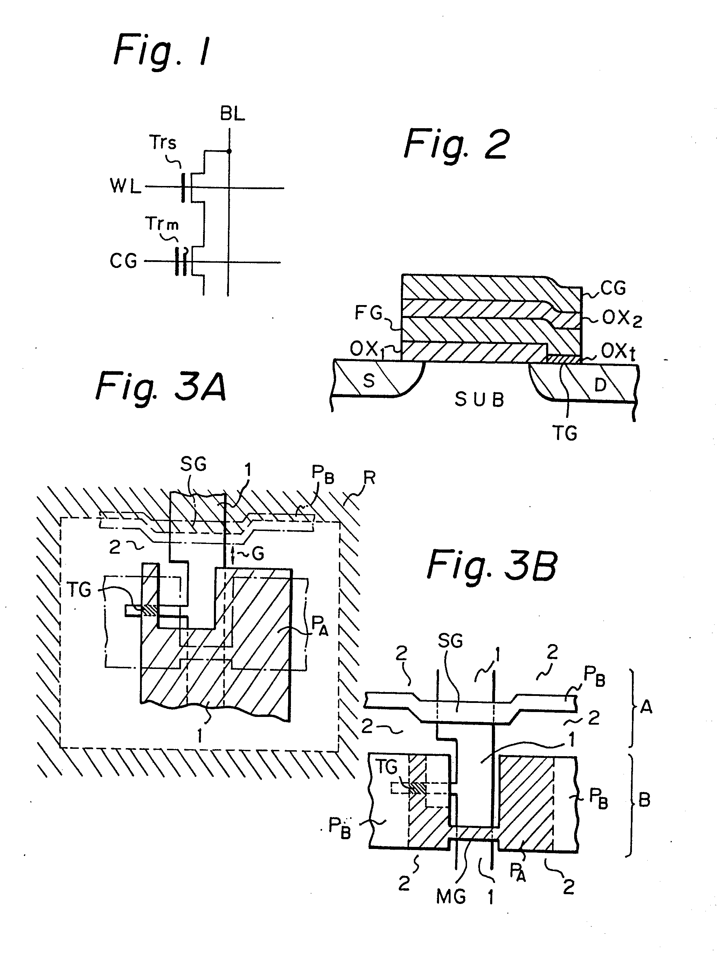

Figure 1 is a circuit diagram of a two-transistor cell.  In Figure 1, BL designates a bit line, WL designates a word line, CG designates a control gate, Trs designates a select transistor, and Trm designates a memory transistor.

Figure 2 is a principle diagram of the structure of the above-mentioned Flotox-type cell transistor. In Fig. 2, SUB designates, for example, a P-type silicon substrate, S designates an $N^+$-type source region, D designates an $N^+$-type drain region, FG designates a floating gate composed of polysilicon, CG designates a control gate composed of polysilicon, TG designates a tunnel gate portion, $OX_1$ designates a first gate oxide film having a thickness of from about 300 $\overset{\circ}{A}$ to about 1500 $\overset{\circ}{A}$, $OX_2$ designates a second gate oxide film having a thickness of from about 300 $\overset{\circ}{A}$ to about 1500 $\overset{\circ}{A}$, and $OX_t$ designates a tunnel gate oxide film having a thickness of from about 80 $\overset{\circ}{A}$ to about 200 $\overset{\circ}{A}$.

In this Flotox-type cell transistor, by maintaining the control gate CG or the drain D at a high level, for example, about 20 V, or at a low level, for example, 0 V, electrons are injected into or emitted from the floating gate FG through the tunnel gate oxide film $OX_t$, whereby the erasing of or the writing of information is effected.

The select transistor (Trs in Fig. 1) which acts on the rewriting of information in the memory transistor (Trm in Fig. 1) has a predetermined threshold voltage (Vth), and it is sufficient if this transistor has an ordinary gate function.

In the conventional two-transistor cell, the select transistor is constructed from an MOS transistor having a single-layer gate structure. In this case, problems due to the preparation process, such as a reduction of the performance and a reduction of the integration density, arise.

Figures 3A and 3B are perspective plane views illustrating a conventional memory cell in which reference numeral 1 designates an active region where a silicon surface is exposed, reference numeral 2 designates a field region where a thick oxide film is formed, $P_A$ designates a first polysilicon layer, $P_B$ designates a second polysilicon layer, MG designates a gate of the memory transistor Trm (shown in Fig. 2) having a two-layer structure, SG designates a gate of the select transistor Trs (shown in Fig. 2) having a single-layer structure, and TG designates a tunnel gate portion. In forming this structure, the floating gate FG (shown in Fig. 2) of the memory transistor Trm is aligned with the control gate CG (shown in Fig. 2) by using the double self-aligning technique.

In Fig. 3A, first, the first gate oxide film $OX_1$ is formed over all of the surface; second, the first polysilicon layer $P_A$ is formed over all of thefirst gate oxide film $OX_1$; third, a resist pattern having the form indicated by the hatched area is formed on the first polysilicon layer $P_A$ , and the first polysilicon layer $P_A$ is patterned by using the resist as a mask. Therefore, the first polysilicon layer $P_A$ becomes as is indicated by the hatched area in Fig. 3A. Then the second gate oxide film $OX_2$ is formed over all of the surface, the second polysilicon layer $P_B$ is formed over all of the surface, and a resist pattern is formed on the second polysilicon layer $P_B$ as is shown by the broken lines, respectively. Next, the second polysilicon layer $P_B$ is patterned by using the resist formed on the second polysilicon layer $P_B$. After finishing the patterning of the second polysilicon layer $P_B$ , the region where the gate of the transistor $T_r$ is formed only by the second polysilicon layer $P_B$ (for example, a peripheral circuit of the memory) is further covered by the resist indicated by R in Fig. 3A so as to prevent unnecessary etching in the next step. Figure 3A shows a case when the resist is formed on the region where the first polysilicon layer $P_A$ does not exist. In this case, the the resist used for patterning is left on the second polysilicon layer $P_B$. Next, the second gate oxide film $OX_2$, the first polysilicon layer $P_A$, and the first gate oxide film $OX_1$ are patterned by using the resist left on the second polysilicon layer $P_B$ as a mask so that the pattern shown in Fig. 3B is obtained.

More specifically, the second polysilicon layer $P_B$ , which is directly formed on the active region through the first gate oxide film ($OX_1$ in Fig. 2) in the select transistor-forming region A and is formed on the polysilicon layer $P_A$ through the second gate oxide film ($OX_2$ in Fig. 2) in the memory transistor-forming region B, is selectively etched, by using a predetermined mask for patterning the region B, to form the gate SG of the select transistor Trs and the control gate CG of the memory transistor Trm, which are composed of the second polysilicon layer $P_B$. Then the exposed second gate oxide film $OX_2$ and the first polysilicon layer $P_A$ located below the second gate oxide film $OX_2$ are selectively etched to form the floating gate FG composed of the first·polysilicon layer $P_A$.

When the second gate oxide film $OX_2$ and the first polysilicon layer $P_A$ are selectively etched, a concave portion, having a depth corresponding to the thickness of the polysilicon of the first layer, for example, from 500 Å to 5,000 Å, and including a side etching portion (undercut portion) below the gate SG of the select transistor Trs, is formed in the active region 1 on the side of the memory transistor Trm, which cannot be covered with a resist because the gap G is narrow in the select transistor-forming region A. When the source region S and drain region D of Fig. 2 are formed by using the gates SG and CG as a mask, the source region S of the select transistor is formed so that it deeply penetrates below the gate SG.

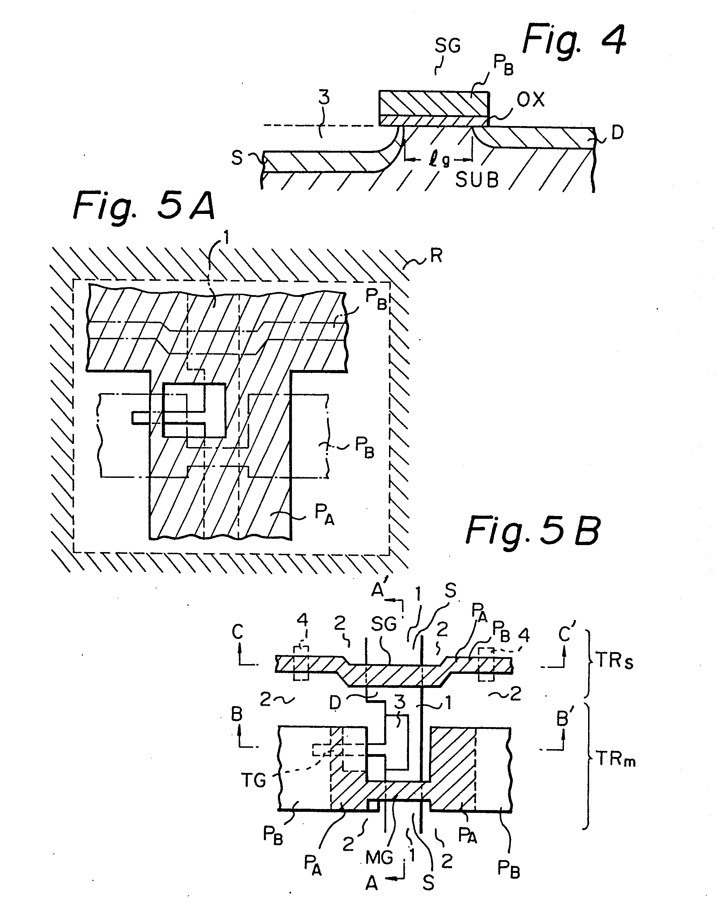

This state is illustrated in Fig. 4, in which SUB designates a P-type silicon substrate, S designates an $N^+$-type source region, D designates an $N^+$-type drain region, OX designates a gate oxide film (corresponding to $OX_2$), SG designates a gate, $P_B$ designates the polysilicon of the second layer, and reference numeral 3 designates a concave portion.

For the purpose of preventing the formation of this concave portion, the resist may be formed on the region between the gate SG and the polysilicon layer $P_A$ when the polysilicon layer $P_B$ is removed. However, on that occasion, the gap G should be large, and, further, the number of processes for forming and patterning the resist should be increased.

In the above-mentioned structure, since the substantial gate length (lg) of the select transistor is shorter than the designed value and the punch-through voltage of the source/drain is reduced, there arises a problem of soft writing in the memory element. If the designed gate length is increased, this undesirable phenomenon is prevented from occurring, but the cell area is increased and the integration density is reduced.

The embodiments of the present invention will now be described in detail with reference to the following drawings.

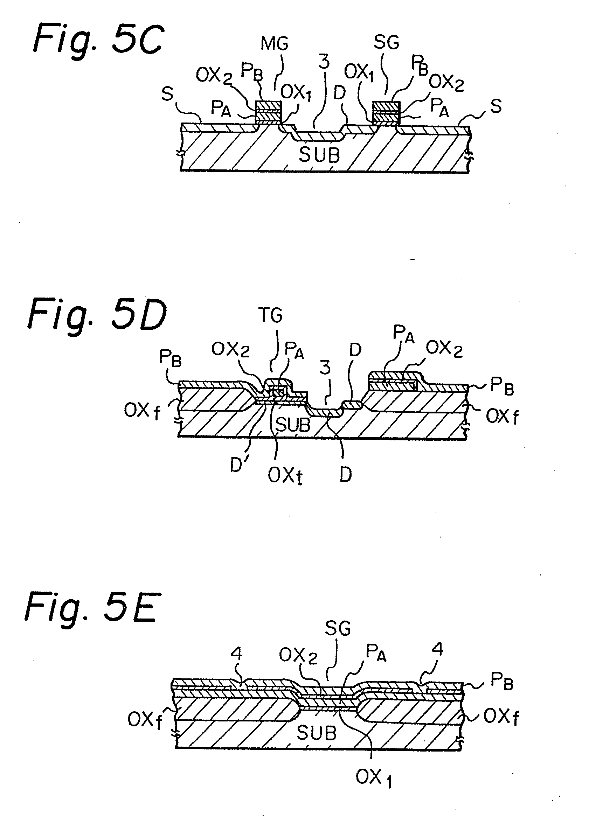

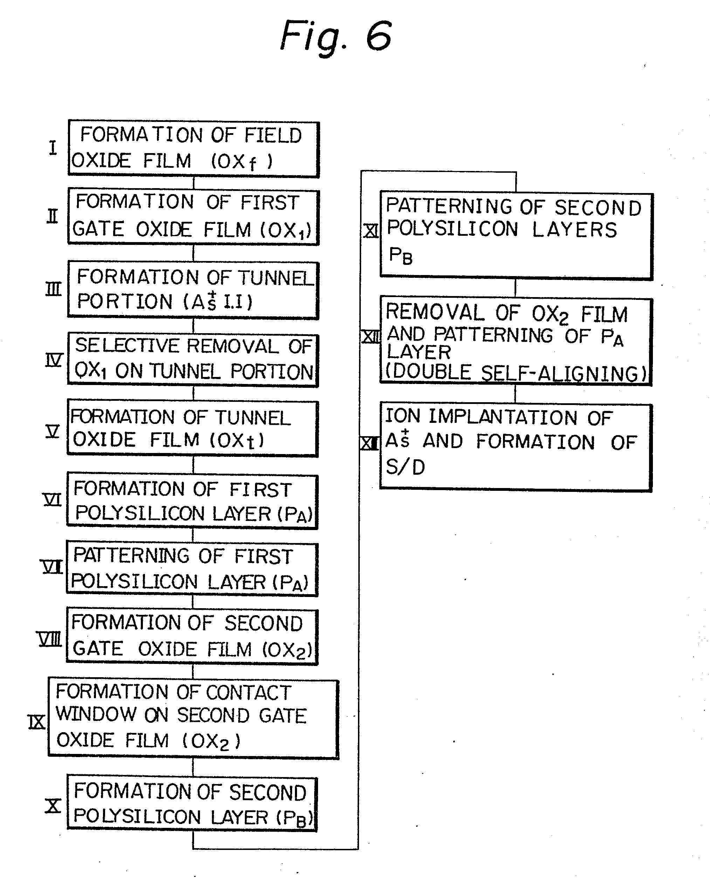

Figures 5A to 5E illustrate one embodiment of the present invention. Figures 5A and 5B are perspective plane views, Fig. 5C is a view of a section taken along the line A-A' in Fig. 5B, Fig. 5D is a view of a section taken along the line B-B' in Fig. 5B, and Fig. 5E is a view of a section taken along the line C-C' in Fig. 5B. Figure 6 is a process diagram illustrating one process for forming the structure of this embodiment.

Figures 5A to 5E illustrate the main structure of a nonvolatile memory element of the Flotox type in which the rewriting of information is accomplished by the tunnel implantation of electrons into the floating gate and to which the present invention is applied.

In Fig. 5A, the steps for forming the first polysilicon layer $P_A$ and the second polysilicon layer $P_B$ are the same as those shown in Fig. 3A except for the third step and the last step. That is, in Fig. 3A, in the third step, the first polysilicon layer $P_A$ is left only on the portion which becomes the gate of the memory transistor while in Fig. 5A the first polysilicon layer $P_A$ is left on the portion which becomes the gate of the select transistor; and in Fig. 5A, in the last step, the first polysilicon layer $P_A$, which is the same in the select transistor as in the memory transistor, is etched by using the resist left on the second polysilicon layer $P_B$ as a mask. Consequently, the pattern shown in Fig. 5 is obtained.

In Figs. 5B to 5E, TRs designates a select transistor region, TRm designates a memory transistor region, $OX_1$ designates a first gate oxide film (formed by thermal oxidation of the substrate and having a thickness of from about 300 Å to about 1500 Å, $OX_2$ designates a second gate oxide film (formed by thermal oxidation of $P_A$ and having a thickness of from about 300 Å to about 1500 Å), $OX_t$ designates a tunnel gate oxide film (formed by thermal oxidation of the substrate separately from $OX_1$ and having a thickness of from about 80 Å to about 200 Å), $OX_f$ designates a field oxide film (having a thickness of from about 8,000 Å to about 10,000 Å), $P_A$ designates a first layer of polysilicon, $P_B$ designates a second layer of polysilicon, SUB designates a P-type Si substrate, S designates an $N^+$-type source region, D designates an $N^+$-type drain region, D' designates an N-type drain region, SG designates a gate of a select transistor, MG designates a gate of a memory transistor, TG designates a gate of a tunnel portion, reference numeral 1 designates an active region not covered with the field oxide film $OX_f$, reference numeral 2 designates a field region covered with a thick oxide film, reference numeral 3 designates a concave portion formed at the selective etching of $P_A$, and reference numeral 4 designates a $P_A-P_B$ contact window.

The characteristic feature of the present invention is that, as is shown in the above embodiment, the gate SG of the select transistor TRs is formed to have a two-layer gate structure where the first polysilicon layer $P_A$ used as a substantial gate electrode is electrically connected to the second polysilicon layer $P_B$ through the contact window 4 (the polysilicon layers may be connected in another region). By adopting this arrangement, when the memory element is manufactured, a concave portion penetrating below the gate SG is not formed in the active region contiguous to the gate SG of the select transistor, that is, the drain region. Of course, the method for contacting $P_A$ and $P_B$ is not limited to the above-mentioned method. For example, there may be adopted a method in which $P_A$ and $P_B$ are connected to each other by an Al line through an ordinary contact hole.

An embodiment of the process for preparing the structure of the present invention will now be described in detail with reference to the following drawings.

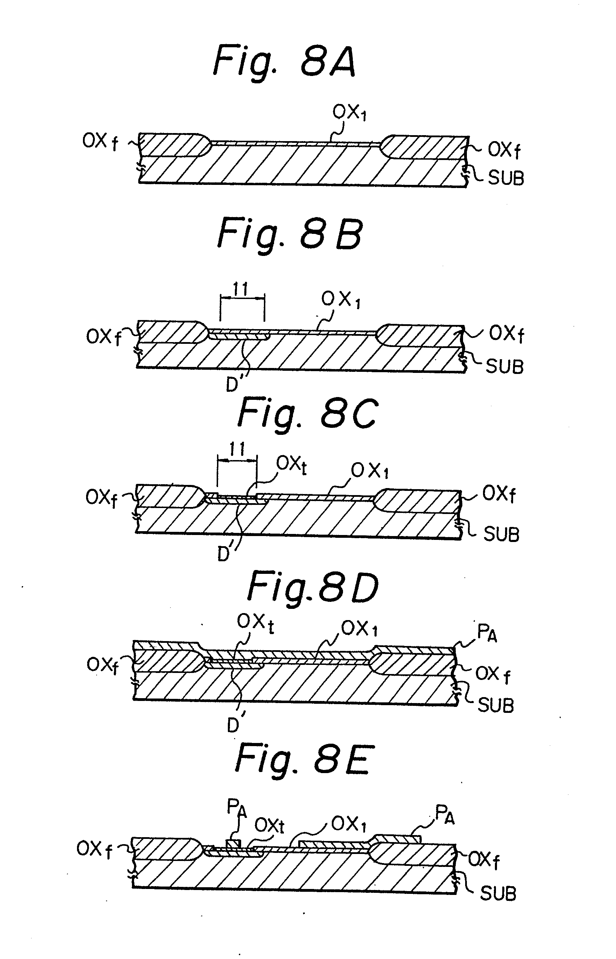

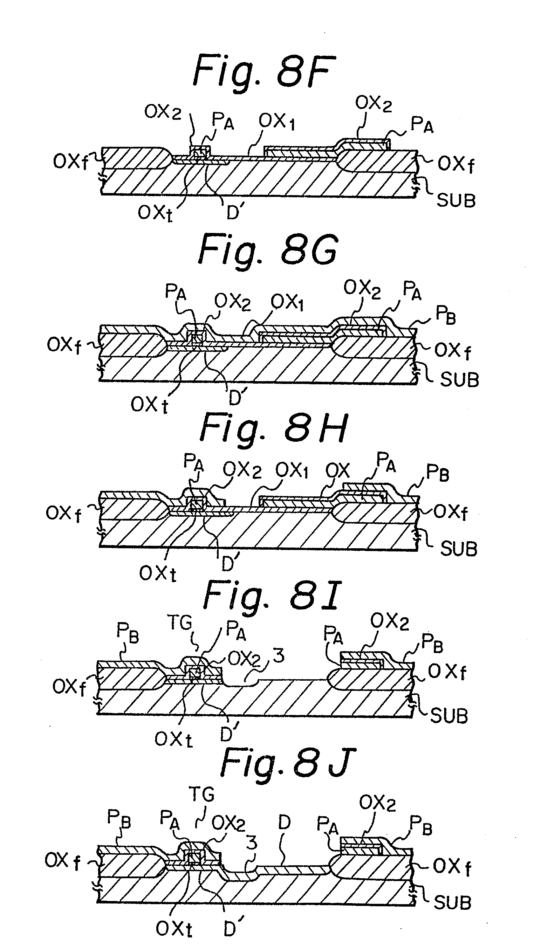

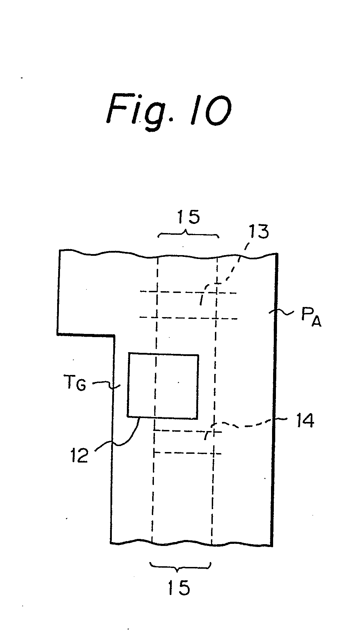

Figure 6 is a process diagram, Figs. 7A to 7H are views of a section taken along the line A-A' in Fig. 5B and illustrate the process steps, Figs. 8A to 8J are views of a section taken along the line B-B' in Fig. 5B and illustrate the process steps, Figs. 9A to 9F are views of a section taken along the line C-C' in Fig. 5B and illustrate the process steps, and Fig. 10 is a plane view of a lower polysilicon pattern.

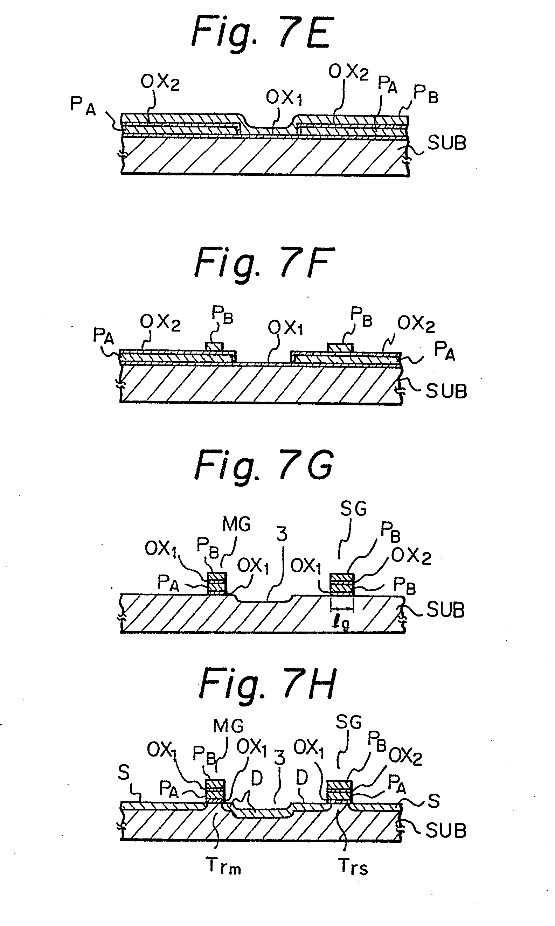

In Figs. 7A to 7H, 8A to 8J, and 9A to 9F, SUB designates a P-type Si substrate, $OX_f$ designates a field oxide film, $OX_1$ designates a first gate oxide film, $OX_2$ designates a second gate oxide film, $OX_t$ designates a tunnel gate oxide film, $P_A$ designates a first layer of polysilicon, $P_B$ designates a second layer of polysilicon, S designates an $N^+$-type source region, D designates an $N^+$-type drain region, D' designates an N-type drain region, SG designates a gate of a select transistor, MG designates a gate of a memory transistor, TG designates a gate of a tunnel portion, and lg in Fig. 7G designates a substantial gate length.

In the production of a memory element having the structure of the above embodiment, the operation is conducted, for example, according to the process diagram of Fig. 6. In Fig. 6, the steps for forming the resist are not shown.

In step I, a field oxide film $OX_f$ is formed on a P-type Si substrate SUB by ordinary selective oxidation. In step II, a first gate oxide film $OX_1$ having a thickness of from about 300 Å to about 1500 Å is formed on the exposed surface of the substrate according to the thermal oxidation method. This state is shown in Fig. 7A, Fig. 8A, and Fig. 9A.

In step III, for example, arsenic (As) is selectively ion-implanted, as is shown in Fig. 8B, in a tunnel oxide film-forming portion 11 and an area adjacent thereto, whereby an N-type drain region D' is formed. The state of other regions is not different from the state at the time of termination of the preceding step.

In step IV, the first gate oxide film $OX_1$ in the tunnel oxide film-forming portion 11 is selectively removed. In step V, a tunnel gate oxide film $OX_t$ having as small a thickness as from about 80 Å to about 200 Å is formed in the portion 11 according to the ordinary thermal oxidation method. This state is shown in Fig. 8C. No particular change is brought about in other regions.

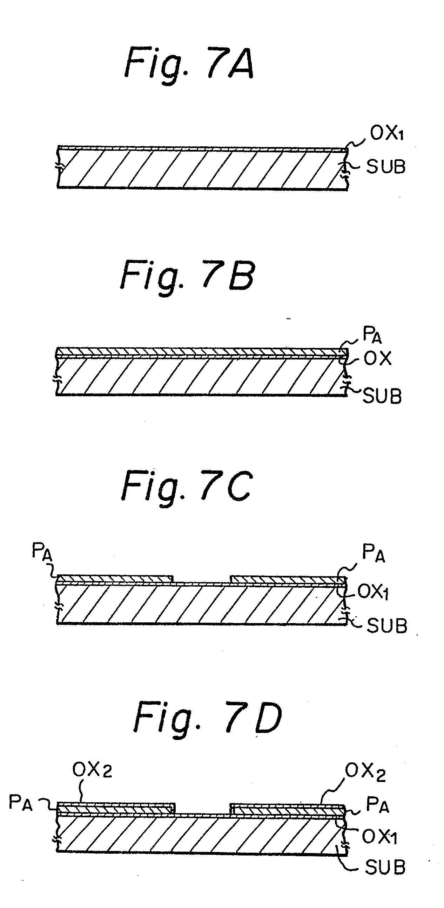

In step VI, a first polysilicon layer $P_A$ having a thickness of from about 500 Å to about 5,000 Å is formed on the substrate according to a chemical vapor deposition (CVD) method. An N-type electric conductivity is given to the first polysilicon layer $P_A$ at the time of deposition or by ion implantation. This state is shown in Fig. 7B, Fig. 8D, and Fig. 9B.

In step VII, patterning of the first polysilicon layer $P_A$ is carried out according to the customary photoetching method (utilizing the dry etching technique). The state at the time of completion of this patterning is illustrated in Fig. 7C, Fig. 8E, and Fig. 9C.

At this patterning step VII, only the width (gate length) of the tunnel gate is defined by a window formed in the first polysilicon layer $P_A$, and the surfaces of active regions close to a gate (SG in Fig. 5B) of a select transistor and a gate (MG in Fig. 5B) of a memory transistor are not exposed. Figure 10 shows the shape of the pattern of the first polysilicon layer $P_A$. In Fig. 10, $P_A$ designates a first polysilicon layer, TG designates a tunnel gate, reference numeral 12 designates a window formed in the layer $P_A$, reference numeral 13 designates a region for the formation of a gate SG of a select transistor, reference numeral 14 designates a region for the formation of a gate MG of a memory transistor, and reference numeral 15 designates an active region.

In step VIII, a second gate oxide film $OX_2$ having a thickness of from about 700 Å to about 800 Å is formed on the first polysilicon layer $P_A$ according to the ordinary thermal oxidation method. This state is shown in Fig. 7D, Fig. 8F, and Fig. 9D.

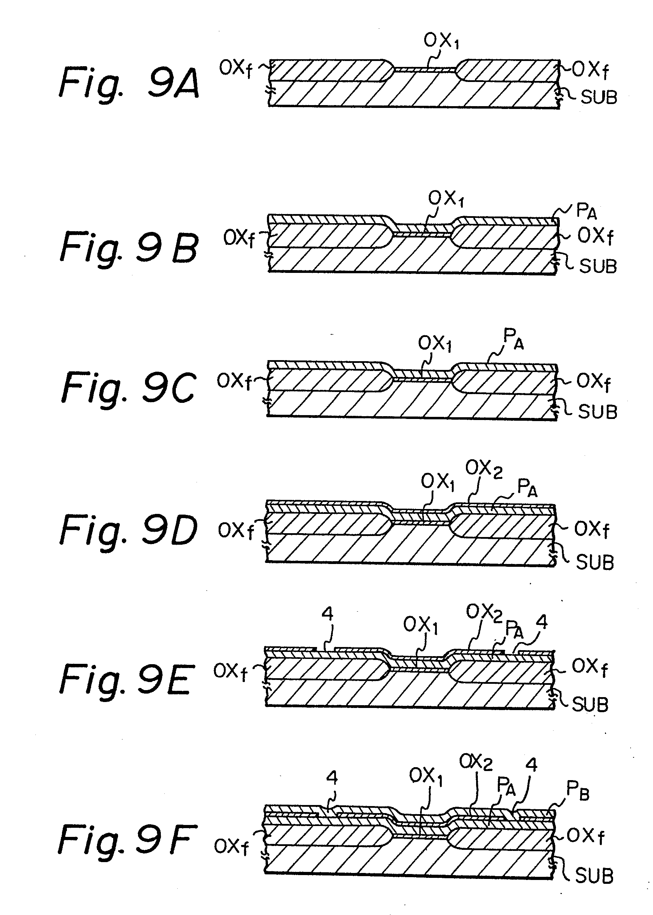

In step IX, a contact window 4 (Fig. 9) for electrically communicating the first polysilicon layer $P_A$ with the second polysilicon layer $P_B$ is formed on the second gate oxide film $OX_2$ according to the customary photoetching method. No particular change is brought about in other regions at this step.

In step X, a second polysilicon layer $P_B$ having a thickness of from about 500 Å to about 5,000 Å is

formed on the substrate according to the CVD method. This state is shown in Fig. 7E, Fig. 8G, and Fig. 9F.

In steps XI and XII, patterning of the second polysilicon layer $P_B$ and the first polysilicon layer $P_A$ is carried out according to the double self-aligning technique. More specifically, at first, patterning of the second polysilicon layer $P_B$ is effected by a first dry etching through a resist mask (not shown). The state after this patterning is shown in Fig. 7F, Fig. 8H, and Fig. 9F.

In step XII, a second dry etching is carried out through the same resist mask to remove the exposed second gate oxide film $OX_2$, and, subsequently, patterning of the first polysilicon layer $P_A$ is effected to complete the formation of a gate SG of a select transistor having a two-layer structure, a gate MG of a memory transistor, and a gate TG of a tunnel portion. At this step, a concave portion 3 (Figs. 7G and 8I) having a thickness corresponding substantially to the thickness of the first polysilicon layer $P_A$ is formed on the surface of the substrate in the portion corresponding to the window of the first polysilicon layer $P_A$ where only the second polysilicon layer $P_B$ is formed. However, since the concave portion 3 is not in contact with the gate SG of the select transistor (and the gate MG of the cell transistor), no side etching portion (undercut portion) is formed below the gate SG and the designed gate length lg is maintained. This state is shown in Fig. 7G, Fig. 8I, and Fig. 9F.

In step XIII, ion implantation of, for example, $As^+$ is effected on the exposed surface of the substrate by using the above-mentioned gates as a mask to form an $N^+$-type source region S and an $N^+$-type drain region D. The state after the formation of the source and drain is shown in Fig. 7H, Fig. 8J, and Fig. 9F.

Then insulating films and lines are formed (the steps are not shown in the drawings). Thus, a semi- conductor memory element of the present invention having a two-transistor cell structure provided with a select transistor having a two-layer gate where the first polysilicon layer $P_A$ is electrically communicated with the second polysilicon layer $P_B$ is formed.

As is apparent from the foregoing description, according to the present invention, in the process for the production of a nonvolatile semiconductor memory element having a two-transistor cell structure, shortening of the gate length of a select transistor to below the designed length is prevented.

Accordingly, the punch-through voltage between the source and drain in the select transistor is maintained at a predetermined level, and the reliability of information is increased.

The present invention may be applied to memory elements other than the above-mentioned Flotox-type semiconductor memory element. Furthermore, the present invention may be applied in a case where a metal silicide is used as a gate electrode.

C L A I M S

1.    A semiconductor memory element having a two-transistor cell structure comprising a memory transistor (Trm) including a floating gate (FG) formed on a semiconductor substrate (SUB) through a first insulating layer ($OX_1$) and a control gate (CG) superimposed on the floating gate (FG) above a second insulating layer ($OX_2$), and a select transistor (Trs) for selecting the memory transistor, wherein the select transistor (Trs) includes a first gate electrode ($P_A$) formed on a first insulating layer ($OX_1$) characterised in that the select transistor (Trs) also includes a second gate electrode ($P_B$) superimposed on the first gate electrode ($P_A$) above a second insulating layer ($OX_2$), the first and second gate electrodes being electrically connected to one another (4).

2.    A method of manufacturing a semiconductor memory element having a two-transistor cell structure comprising a memory transistor (Trm) including a floating gate (FG) formed on a semiconductor substrate (SUB) above a first insulating layer ($OX_1$) and a control gate (CG) superimposed on the floating gate (FG) above a second insulating layer ($OX_2$), and a select transistor (Trs) for selecting the memory transistor (Trm), the method comprising the steps of:-

        forming a field oxide film ($OX_1$) on a semiconductor substrate (SUB);

        forming a first gate insulation film on an exposed surface of the semiconductor substrate;

        forming a first conductive layer ($P_A$) on the semiconductor substrate (SUB);

patterning the first conductive layer (PA);

forming a second gate insulation film ($OX_2$) on the first conductive layer ($P_A$);

forming a contact window (4) on the second gate insulation film ($OX_2$); for electrically communicating the first conductive layer with a second conductive layer;

forming a second conductive layer ($P_B$) on the second gate insulation film ($OX_2$) and over the contact window (4) to electrically connect the second and first conductive layers ($P_A$ and $P_B$);

patterning the second conductive layer ($P_B$) to form the control gate (CG) and another second gate (SG);

removing the exposed second gate insulation film ($OX_2$) and patterning the first conductive layer ($P_A$) to form a first gate of the select transistor (Trs) and the floating gate (FG) of the memory transistor (Trm); and,

forming a source region (S) and a drain region (D) in the semiconductor substrate (SUB).

Fig. 1

Fig. 2

Fig. 3A

Fig. 3B

Fig. 4

Fig. 5 A

Fig. 5 B

*Fig. 5C*

*Fig. 5D*

*Fig. 5E*

# Fig. 6

I — FORMATION OF FIELD OXIDE FILM (OX$_f$)

II — FORMATION OF FIRST GATE OXIDE FILM (OX$_1$)

III — FORMATION OF TUNNEL PORTION (A$\overset{+}{s}$ I.I)

IV — SELECTIVE REMOVAL OF OX$_1$ ON TUNNEL PORTION

V — FORMATION OF TUNNEL OXIDE FILM (OX$_t$)

VI — FORMATION OF FIRST POLYSILICON LAYER (P$_A$)

VII — PATTERNING OF FIRST POLYSILICON LAYER (P$_A$)

VIII — FORMATION OF SECOND GATE OXIDE FILM (OX$_2$)

IX — FORMATION OF CONTACT WINDOW ON SECOND GATE OXIDE FILM (OX$_2$)

X — FORMATION OF SECOND POLYSILICON LAYER (P$_B$)

XI — PATTERNING OF SECOND POLYSILICON LAYERS P$_B$

XII — REMOVAL OF OX$_2$ FILM AND PATTERNING OF P$_A$ LAYER (DOUBLE SELF-ALIGNING)

XIII — ION IMPLANTATION OF A$\overset{+}{s}$ AND FORMATION OF S/D

Fig. 7A

Fig. 7B

Fig. 7C

Fig. 7D

## Fig. 7E

## Fig. 7F

## Fig. 7G

## Fig. 7H

## Fig. 8A

OX$_1$

OX$_f$ · · · · · · · · · · · · · · · · · · · · · OX$_f$

SUB

## Fig. 8B

11

OX$_1$

OX$_f$ · · · · · · · · · · · · · · · · · · · · · OX$_f$

D' · · · · · · · · · SUB

## Fig. 8C

11 · · · OX$_t$ · · · OX$_1$

OX$_f$ · · · · · · · · · · · · · · · · · · · · · OX$_f$

D' · · · · · · · · · SUB

## Fig. 8D

OX$_t$ · · · OX$_1$ · · · P$_A$

OX$_f$ · · · · · · · · · · · · · · · · · · · · · OX$_f$

D' · · · · · · · · · SUB

## Fig. 8E

P$_A$ · OX$_t$ · · · OX$_1$ · · · · · P$_A$

OX$_f$ · · · · · · · · · · · · · · · · · · · · · OX$_f$

SUB

## Fig. 8F

## Fig. 8G

## Fig. 8H

## Fig. 8I

## Fig. 8J

Fig. 9A

Fig. 9 B

Fig. 9C

Fig. 9D

Fig. 9E

Fig. 9 F

10|10

# Fig. 10